# EUROPEAN PATENT APPLICATION

(11) **EP 1 662 265 A1**
(43) Date of publication of application: **31.05.2006**
(21) Application number: 04747134.7
(22) Date of filing: 07.07.2004
(51) Int. Cl.: G01R 31/28

(54) **PATTERN GENERATION DEVICE AND TEST DEVICE**

(30) Priority: 22.07.2003 JP 2003277278
(71) Applicant: ADVANTEST CORPORATION, Nerima-ku, Tokyo 179-0071 (JP)
(72) Inventor: NAKAYAMA, Hiroyasu, Nerima-ku, Tokyo 1790071 (JP)
(74) Representative: Pfenning, Meinig & Partner GbR
(86) International application number: PCT/JP2004/009665
(87) International publication number: WO 2005/008263

(57) **Abstract**

There is provided a pattern generator that generates a test pattern for performing a scan test for an electronic device. The pattern generator includes: a main memory that stores a scan pattern data block including pattern data for performing the scan test and a scan sequence data block including an instruction indicative of a sequence by which data in the scan pattern data block should be supplied to the electronic device, in association with each other; and a data expanding section that executes the instruction in the scan sequence data block to expand the pattern data in the corresponding scan pattern data block and generate the test pattern.

## Description

### BACKGROUND OF THE INVENTION

### Field of the Invention

The present invention relates to a pattern generator and a test apparatus. More particularly, the present invention relates to a pattern generator and a test apparatus for testing an electronic device. The present application also relates to the following application, the contents of which are incorporated herein by reference if applicable.
A Japanese Patent Application No. 2003-277278
Filed on July 22, 2003.

### Description of Related Art

Conventionally, a pattern generator that generates a test pattern has been used in a test apparatus performing a function test and a scan test for an electronic device. The pattern generator has a memory that stores data to generate the test pattern. When the function test is performed, the pattern generator reads pattern data and sequence data to generate a test pattern for a function test from the memory, and generates the test pattern. Moreover, when the scan test is performed, the pattern generator reads pattern data for a scan test from the memory, and outputs the pattern data as a test pattern.

Moreover, a trend of using many bits to operate the electronic device is recently remarkable. For this reason, the number of output pins of the electronic device, which have logical values of output signal inverted simultaneously, is increased, and thus a noise is produced in an output signal. To reduce this noise, there is an electronic device that inverts and outputs output data every cycle of the output signal. In other words, when there increases the number of output pins for inverting the output data with respect to a previous cycle, the electronic device reduces the number of output pins having the inverted output data with respect to the previous cycle by inverting and outputting the data output from each output pin. In this case, the electronic device further outputs an inversion cycle signal showing the effect that the output signal for the cycle has been inverted.

### SUMMARY OF THE INVENTION

### Problems to be solved by the Invention

However, in a conventional pattern generator, since it is necessary to store the generally same data as a test pattern for scan test on a memory as pattern data, there has been required a high-capacity memory.

Therefore, it is an object of the present invention to provide a pattern generator and a test apparatus that can solve the foregoing problems. The above and other objects can be achieved by combinations described in the independent claims. The dependent claims define further advantageous and exemplary combinations of the present invention.

### Means for Achieving the Objects

To solve this problem, according to the first aspect of the present invention, there is provided a pattern generator that generates a test pattern for performing a scan test for an electronic device. The pattern generator includes: a main memory that stores a scan pattern data block including pattern data for performing the scan test and a scan sequence data block including an instruction indicative of a sequence by which data in the scan pattern data block should be supplied to the electronic device, in association with each other; and a data expanding section that executes the instruction in the scan sequence data block to expand the pattern data in the corresponding scan pattern data block and generate the test pattern.

The main memory may store a plurality of the scan pattern data blocks on a continuous area and store a plurality of the scan sequence data blocks on a continuous area. Moreover, during executing the instruction in the scan sequence data block, when a repeat instruction by which pattern data in a predetermined area in the corresponding scan pattern data block should be repeatedly expanded has been detected, the data expanding section may repeatedly expand the pattern data in the predetermined area

The data expanding section may include: a sequence cache memory that stores the scan sequence data block to be sequentially executed; and a pattern cache memory that stores the scan pattern data block corresponding to the scan sequence data block stored on the sequence cache memory, and the pattern generator may further include a memory controlling section that sequentially reads the scan sequence data block and the scan pattern data block according to a test pattern to be generated from the main memory and stores them on the sequence cache memory and the pattern cache memory.

According to the second aspect of the present invention, there is provided a test apparatus that tests an electronic device. The test apparatus includes: a pattern generator that generates a test pattern for testing the electronic device; a waveform shaper that shapes the test pattern; and a deciding section that decides the good or bad of the electronic device based on an output signal output from the electronic device based on the test pattern, in which the pattern generator generates a test pattern for performing a scan test for the electronic device, and includes: a main memory that stores a scan pattern data block including pattern data for performing the scan test and a scan sequence data block including an instruction indicative of a sequence by which data in the scan pattern data block should be supplied to the electronic device, in association with each other; and a data expanding section that executes the instruction in the scan sequence data block to expand the pattern data in the corresponding scan pattern data block and generate the test pattern.

The test apparatus may perform a function test and a scan test for the electronic device, and the pattern generator may generate a test pattern for the scan test according to an instruction by which the test pattern for the scan test should be generated when a test pattern for the function test is generated .

The electronic device may include a normal pin for performing the function test and a scan pin for performing the scan test, and the pattern generator may supply the test pattern to the normal pin and the scan pin and supplies the generally same pattern to the normal pin according to the instruction by which the test pattern for the scan test should be generated until the generation of the test pattern for the scan test is terminated.

When the instruction by which the test pattern for the scan test should be generated has been detected, the pattern generator may supply the last pattern in the test pattern for the function test, which is generated just before, to the normal pin until the generation of the test pattern for the scan test is terminated.

The summary of the invention does not necessarily describe all necessary features of the present invention. The present invention may also be a sub-combination of the features described above.

### Effects of the Invention

According to the present invention, a test pattern can be generated efficiently. Moreover, an electronic device can be tested efficiently. Moreover, a capacity of a use memory can be reduced.

### BRIEF DESCRIPTION OF THE DRAWINGS

Fig. 1 is a view exemplary showing a configuration of a test apparatus according to an embodiment of the present invention. (Embodiment 1)

Fig. 2 is a view exemplary showing a configuration of a pattern generator.

Fig. 3 is a view exemplary showing a configuration of a data expanding section.

Fig. 4 is a view exemplary showing data structure of a main memory.

Fig. 5 is a view showing another example of a configuration of the test apparatus. (Embodiment 2)

Fig. 6 is a view exemplary showing test patterns output from the pattern generator corresponding to each pin.

### DETAILED DESCRIPTION OF THE INVENTION

The invention will now be described based on the preferred embodiments, which do not intend to limit the scope of the present invention, but exemplify the invention. All of the features and the combinations thereof described in the embodiment are not necessarily essential to the invention.

### (Embodiment 1)

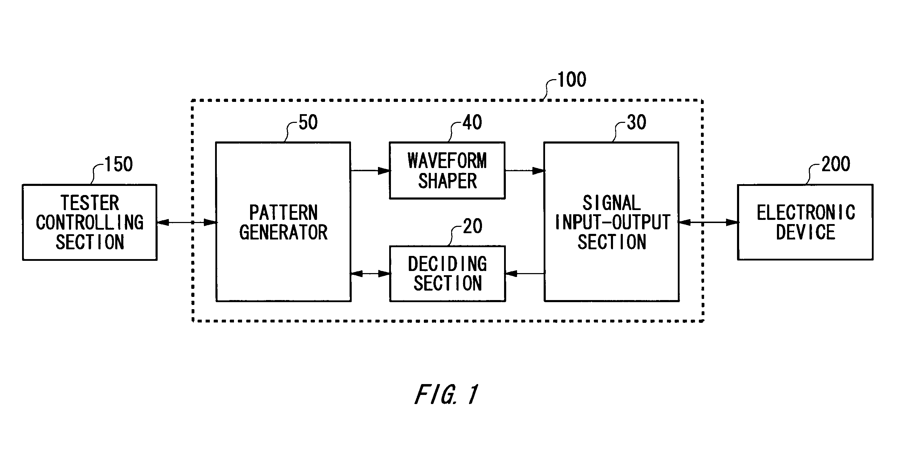

Fig. 1 is a view exemplary showing a configuration of a test apparatus 100 according to an embodiment of the present invention. The test apparatus 100 tests an electronic device 200. The test apparatus 100 includes a pattern generator 50, a waveform shaper 40, a signal input-output section 30, and a deciding section 20. Here, the electronic device 200 indicates a device that operates according to a given electrical signal. For example, the electronic device is a semiconductor circuit such as an IC chip or LSI having a semiconductor device.

The pattern generator 50 receives test data, with which the electronic device 200 should be tested, from a tester controlling section 150 provided outside, and generates a test pattern for testing the electronic device 200 based on the test data. The tester controlling section 150 is a computer such asaworkstation. Moreover, the pattern generator 50 may generate an expected value signal showing an expected value to be output from the electronic device 200 based on the input test pattern.

The waveform shaper 40 receives and shapes the test pattern, and supplies it to the signal input-output section 30 in a desired timing. The signal input-output section 30 supplies thereceivedtestpatterntothe electronic device 200,andreceives an output signal output from the electronic device 200 based on the test pattern. Moreover, the signal input-output section 30 supplies the received output signal to the deciding section 20.

The deciding section 20 decides the good or bad of the electronic device 200 based on the received output signal. For example, the deciding section 20 receives the expected value signal from the pattern generator 50, and compares the expected value signal and the output signal from the electronic device 200 to decide the good or bad of the electronic device 200.

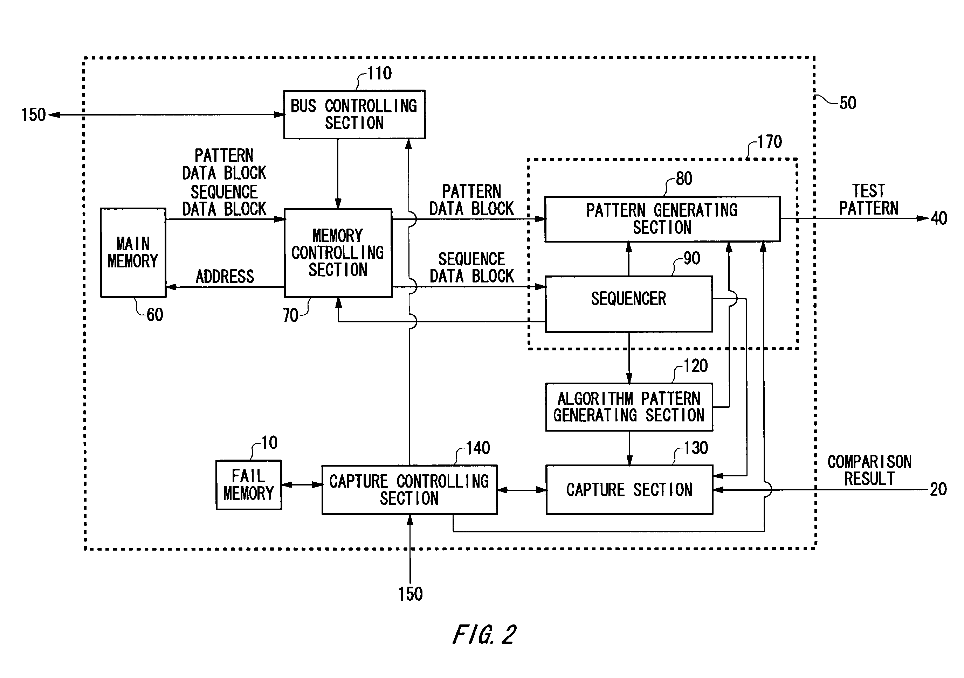

Fig. 2 is a view exemplary showing a configuration of the pattern generator 50. The pattern generator 50 includes a main memory 60, a data expanding section 170, a sequencer 90, a bus controlling section 110, an algorithm pattern generating section 120, a capture section 130, a capture controlling section 140, and a fail memory 10. The data expanding section 170 has a pattern generating section 80 and the sequencer 90.

The main memory 60 stores the test data for generating the test pattern. The test data are divided into a plurality of test data blocks and stored. For example, the main memory 60 stores a plurality of pattern data blocks obtained by dividing pattern data showing a signal to be supplied to the electronic device 200 and a plurality of sequence data blocks obtained by dividing sequence data indicating a sequence by which the pattern data should be supplied to the electronic device 200, as the test data blocks. Moreover, themainmemory 60 stores the pattern data blocks and the sequence data blocks in association with each other.

The buscontrollingsection 110 receivesinstruction information showing a sequence, by which the test data blocks should be supplied to the pattern generating section 80 and/or the sequencer 90, from the tester controlling section 150, and sequentially instructs a memory controlling section 70 which pattern data block and/or sequence data block should be read from the main memory 60 based on the instruction information. The memory controlling section 70 sequentially reads the pattern data blocks and the sequence data blocks from the main memory 60 based on the instruction received from the bus controlling section 110, and sequentially supplies the read pattern data blocks to the pattern generating section 80 and sequentially supplies the read sequence data blocks to the sequencer 90.

The pattern generating section 80 sequentially receives the pattern data blocks, and generates a test pattern based on the pattern data blocks. The sequencer 90 sequentially stores the received sequence data blocks, and controls the pattern generating section 80 based on the stored sequence data blocks. For example, the sequence data block is a program for instructing a sequence, by which data in the pattern data block should be output, and generating a test pattern, and makes the pattern generating section 80 generate a test pattern according to the program. The sequencer 90 may sequentially instruct addresses for the pattern data blocks to be out put from the pattern generating section 80 to the pattern generating section 80 based on the sequence data blocks.

Moreover, when the electronic device 200 to be tested is a memory, the sequencer 90 may supply an instruction signal to generate pattern data for testing a memory to the algorithm patterngeneratingsection 120. Thealgorithmpatterngenerating section 120 generates the pattern data for testing a memory based on a preset algorithm when receiving the instruction signal. In this case, the pattern generating section 80 generates the test pattern further based on the pattern data for testing a memory.

The capture section 130 and the capture controlling section 140 store a decision result by the deciding section 20 on the fail memory 10. The capture section 130 receives either an address for the pattern data block instructed to the pattern generating section 80 by the sequencer 90 or data for testing a memory generated from the algorithmpattern generating section 120, or both. The capture section 130 gives either of an address for the corresponding pattern data block or data for testing the corresponding memory, or both to the decision result. The capture controlling section 140 receives an instruction signal instructing whether the decision result should be stored on the fail memory 10 from the tester controlling section 150, and supplies the decision result to the fail memory 10 according to the instruction signal.

Moreover, the capture controlling section 140 may inform the bus controlling section 110 of a decision result for the pattern data block when a test by one pattern data block has been terminated. In this case, the bus controlling section 110 informs the tester controlling section 150 of the decision result.

Moreover, the fail memory 10 stores the decision result by the deciding section 20. Thetestercontrollingsection 150 may read the decision result stored on the fail memory 10 to analyze a test result of the electronic device 200, or may analyze a test result based on the decision result every pattern data block. Moreover, in this example, the pattern generator 50 has the fail memory 10. However, in another example, the pattern generator 50 do not have the fail memory 10, but the test apparatus 100 may have the fail memory 10 or the tester controlling section 150 may have the fail memory 10.

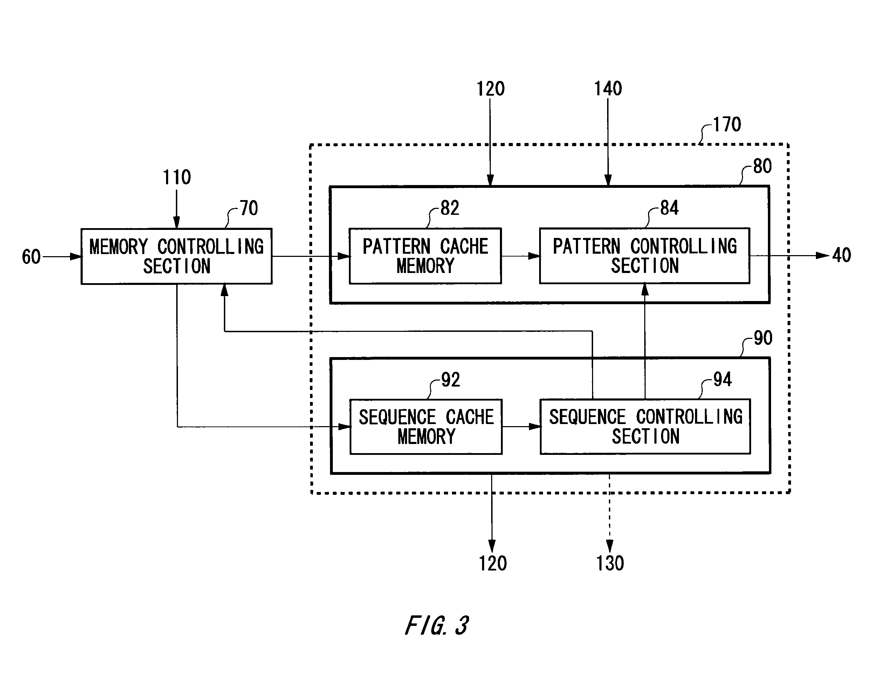

Fig. 3 is a view exemplary showing a configuration of the data expanding section 170. The pattern generating section 80 has a pattern cache memory 82 and a pattern controlling section 84. The sequencer 90 has a sequence cache memory 92 and a sequence controlling section 94. The pattern cache memory 82 stores a pattern data block and the sequence cache memory 92 stores a sequence data block. It is preferable that the pattern cache memory 82 and the sequence cache memory 92 have an address space that can store a plurality of data blocks.

The pattern controlling section 84 generates a test pattern based on a pattern data block stored on the pattern cache memory 82. For example, the pattern controlling section 84 sequentially receives addresses for the pattern cache memory 82 from the sequence controlling section 94, sequentially outputs pattern data of the received addresses, and generates a test pattern.

The sequence controlling section 94 sequentially takes out sequence data blocks stored on the sequence cache memory 92 to execute them. For example, the sequence data block is an instruction group including a jump instruction, a repeat instruction, a return instruction, or the like, and the sequence controlling section 94 sequentially supplies addresses for the pattern cache memory 82 to the pattern controlling section 84 based on an instruction in the sequence data block.

Moreover, when the sequence controlling section 94 detects a pre-fetch instruction by which another sequence data block should be pre-fetched during executing the sequence data block, the sequence controlling section 94 informs the memory controlling section 70 of the pre-fetch instruction. The memory controlling section 70 reads a sequence data block and a corresponding pattern data block from the main memory 60 to store them on the pattern cache memory 82 and the sequence cache memory 92 based on the informed pre-fetch instruction.

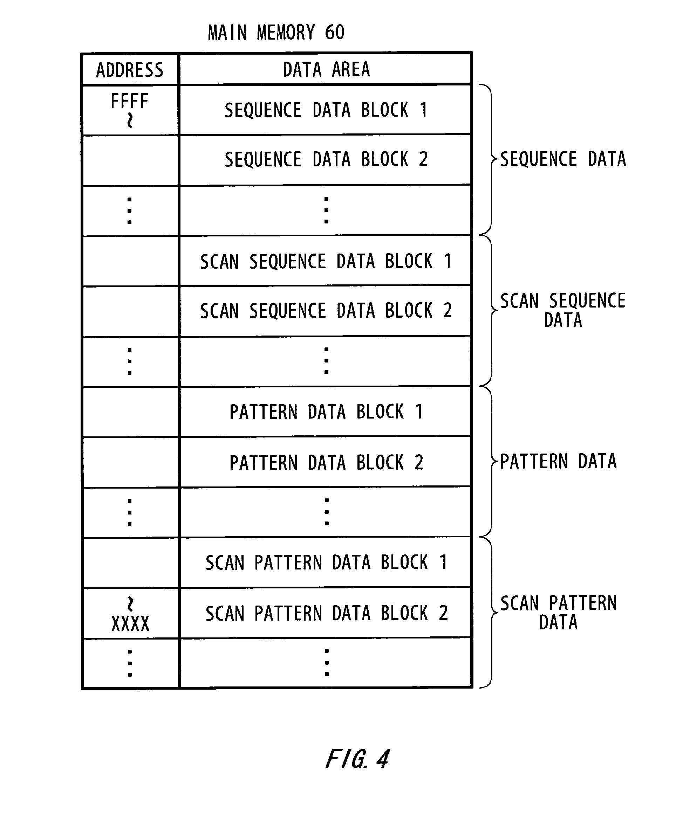

Fig. 4 is a view exemplary showing a data structure of the main memory 60. In this example, the test apparatus 100 performs a function test and a scan test for the electronic device 200. Here, a function test means a test testing a logic section of the electronic device 200, and a scan test means a test using a scan path of the electronic device. The scan test includes a test of which a test specification is determined by, e.g., IEEE 1149.1.

The main memory 60 stores a plurality of sequence data blocks, a plurality of scan sequence data blocks, a plurality of pattern data blocks, and a plurality of scan pattern data blocks. The sequence data block and the pattern data block are data blocks to perform a function test, and the scan sequence data block and the scan pattern data block are data blocks to perform a scan test.

The main memory 60 may store the pattern data block in association with either of the sequence data blocks. Moreover, the main memory 60 may store the scan pattern data block in association with either of scan sequence data blocks. The scan pattern data block includes pattern data to perform a scan test, and the scan sequence data block includes an instruction showing an order by which data in the scan pattern data block should be supplied to the electronic device 200.

When performing a scan test, the pattern cache memory 82 stores the scan pattern data block and the sequence cache memory 92 stores the scan sequence data block. The sequence controlling section 94 sequentially executes instructions in the scan sequence data block stored on the sequence cache memory 92, and sequentially informs the pattern controlling section 84 of addresses for the pattern cache memory 82.

The pattern controlling section 84 expands pattern data in the scan pattern data block stored on the pattern cache memory 82 based on the informed address, and generates a test pattern for scan test. The scan sequence data block includes a repeat instruction by which pattern data in a predetermined address range should be output repeatedly. By the repeat instruction, the pattern controlling section 84 repeatedly outputs pattern data in a predetermined address range. For this reason, the main memory 60 does not need to redundantly store data pattern to be repeatedly used in a test pattern for scan test. In other words, the main memory 60 can compare the scan pattern data block with a data amount to be output as a test pattern and store the compressed scan pattern data block. Then, the pattern controlling section 84 can expand the compressed scan pattern data block based on the corresponding scan sequence data block.

Moreover, the main memory 60 stores the plurality of scan pattern data blocks on a continuous area, and stores the plurality of scan sequence data blocks on a continuous area. Since the pattern controlling section 84 may pre-fetch another sequence data block by the pre-fetch instruction and start executing the other sequence data block in response to a jump instruction, test patterns can continuously be generated even if data blocks are not stored on the main memory 60 in execution sequence.

In this example, since the pattern generator 50 has sequence data for a scan test and a scan pattern data block can be stored in a compressed format, it is possible to reduce a memory capacity.

### (Embodiment 2)

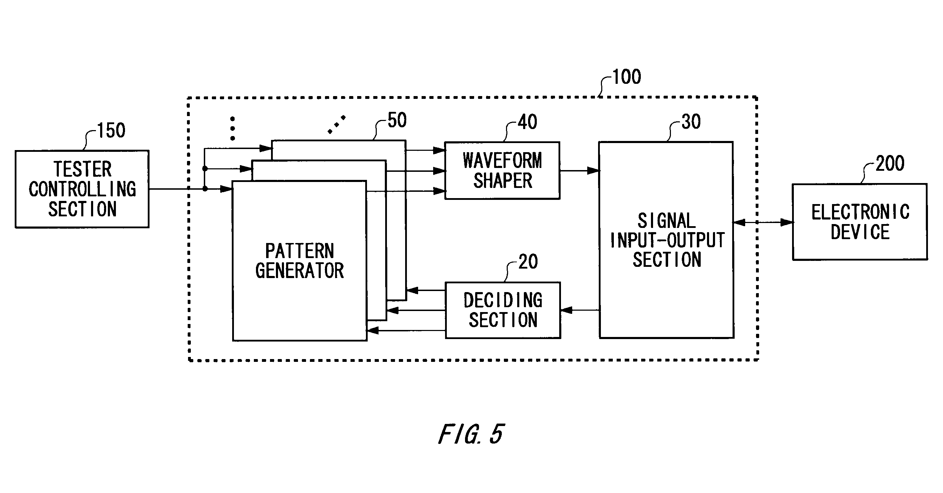

Fig. 5 is a view showing another example of a configuration of the test apparatus 100. The electronic device 200 has a normal pin for a function test and a scan pin for a scan test. Moreover, the scan pin may be used for a function test. In this example, the test apparatus 100 has a plurality of pattern generators 50 corresponding to pins of the electronic device 200.

When generating a test pattern for a function test, the pattern generator 50 corresponding to a scan pin generates a test pattern for scan test when an instruction by which a test pattern for scan test should be generated has been detected. For example, when a jump instruction to be jumped to a scan sequence data block has been detected during executing a sequence data block, a test pattern for scan test is generated based on the scan sequence data block.

Moreover, when the test apparatus 100 is shifted to a scan test, the pattern generator 50 corresponding to a normal pin supplies the same data to the normal pin. For example, data output finally in a function test may be supplied to the normal pin during a scan test.

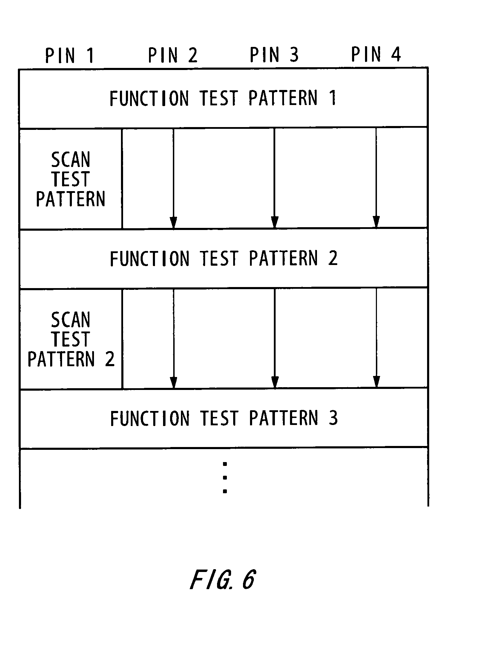

Fig. 6 is a view exemplary showing test patterns generated from the pattern generator 50 corresponding to each pin. In this example, a pin 1 is a scan pin, and pin 2 to pin 4 are normal pins.

As described in Fig. 5, when the test is shifted to a scan test, the pattern generator 50 corresponding to the pin 1 generates a scan test pattern for scan test. Moreover, the pattern generators 50 corresponding to other pins supply the generally same patterns to the normal pins until the scan test is over. For example, the pattern generator holds data output finally among the function test patterns and supplies the data to the normal pin until the scan test is over.

As described above, according to the test apparatus 100 of the present embodiment, since sequence data are used in a scan test, it is possible to use compressed pattern data. For this reason, a capacity of a memory to be used can be reduced. Moreover, test patterns can be generated continuously.

Although the present invention has been described by way of an exemplary embodiment, it should be understood that those skilled in the art might make many changes and substitutions without departing from the spirit and the scope of the present invention. It is obvious from the definition of the appended claims that embodiments with such modifications also belong to the scope of the present invention.

### INDUSTRIAL APPLICABILITY

As apparent from the above descriptions, according to the present invention, it is possible to perform a test for an electronic device that inverts and outputs an output signal every cycle with high precision and efficiently.

## Claims

1. A pattern generator that generates a test pattern for performing a scan test for an electronic device, comprising:
amainmemory that stores a scan pattern data block including pattern data for performing the scan test and a scan sequence data block including an instruction indicative of a sequence by which data in the scan pattern data block should be supplied to the electronic device, corresponding to each other; and
a data expanding section that executes the instruction in the scan sequence data block to expand the pattern data in the corresponding scan pattern data block and generate the test pattern.

2. The pattern generator as claimed in claim 1, wherein said main memory stores a plurality of the scan pattern data blocks on a continuous area and stores a plurality of the scan sequence data blocks on a continuous area.

3. The pattern generator as claimed in claim 1, wherein during executing the instruction in the scan sequence data block, when a repeat instruction by which pattern data in a predetermined area in the corresponding scan pattern data block should be repeatedly expanded has been detected, said data expanding section repeatedly expands the pattern data in the predetermined area.

4. The pattern generator as claimed in claim 1, wherein said data expanding section comprises:
a sequence cache memory that stores the scan sequence data block to be sequentially executed; and
a pattern cache memory that stores the scan pattern data block corresponding to the scan sequence data block stored on the sequence cache memory, and
the pattern generator further comprises a memory controlling section that sequentially reads the scan sequence data block and the scan pattern data block according to a test pattern to be generated from said main memory and stores them on the sequence cache memory and the pattern cache memory.

5. A test apparatus that tests an electronic device, comprising:
a pattern generator that generates a test pattern for testing the electronic device;
a waveform shaper that shapes the test pattern; and
a deciding section that decides the good or bad of the electronic device based on an output signal output from the electronic device based on the test pattern,
wherein said pattern generator generates a test pattern for performing as can test for the electronic device, and comprises:
a main memory that stores a scan pattern data block including pattern data for performing the scan test and a scan sequence data block including an instruction indicative of a sequence by which data in the scan pattern data block should be supplied to the electronic device, in association with each other; and
a data expanding section that executes the instruction in the scan sequence data block to expand the pattern data in the corresponding scan pattern data block and generate the test pattern.

6. The test apparatus as claimed in claim 5, wherein
the test apparatus performs a function test and a scan test for the electronic device, and
said pattern generator generates a test pattern for the scan test according to an instruction by which the test pattern for the scan test should be generated when a test pattern for the function test is generated.

7. The test apparatus as claimed in claim 6, wherein
the electronic device comprises a normal pin for performing the function test and a scan pin for performing the scan test, and
said pattern generator supplies the test pattern to the normal pin and the scan pin and supplies the generally same pattern to the normal pin according to the instruction by which the test pattern for the scan test should be generated until the generation of the test pattern for the scan test is terminated.

8. The test apparatus as claimed in claim 7, wherein when the instruction by which the test pattern for the scan test should be generated has been detected, said pattern generator supplies the last pattern in the test pattern for the function test, which is generated just before, to the normal pin until the generation of the test pattern for the scan test is terminated.
